# EUROPEAN PATENT APPLICATION

(11) **EP 0 613 076 A1**
(43) Date of publication of application: **31.08.1994**
(21) Application number: 94300382.2
(22) Date of filing: 19.01.1994
(51) Int. Cl.: G06F 1/22

(54) **Circuit board receptacle and IC packages for multiple and single supply circuits**

(30) Priority: 27.01.1993 US 9723
(71) Applicant: NATIONAL SEMICONDUCTOR CORPORATION, Santa Clara, California 95052-8090 (US)
(72) Inventor: Davis, Jeffrey, Raymond, Maine 04071 (US)
(74) Representative: Bowles, Sharon Margaret

(57) **Abstract**

Complementary pad and pin configurations are provided for the pads of a system board receptacle (20) and the pins of alternative first and second IC packages (15,25) to be inserted in the receptacle. The system board accommodates multiple power supplies. The system board receptacle is constructed with a pad configuration having a first power supply pad and trace (VCCA) for coupling to a first power supply, and second and third power supply pads and traces (VCCB1,VCCB2) for coupling to a second power supply. A first IC package is constructed with a pin configuration for a first IC package (15) requiring multiple power supplies includes a first power supply pin (VCCA) coinciding with the first power supply pad and trace of the system board receptacle and a second power supply pin (VCCB1) coinciding with the second power supply pad and trace for supplying portions of the integrated circuit of the first IC package from different power supplies. The first IC package is formed with a third no-connect pin coinciding with a third power supply pad and trace (VCCB2) of the system board receptacle 20. A second IC package pin configuration includes a single power supply pin (VCCB2) coinciding with the third power supply pad and trace of the system board receptacle (20). The second IC package pin configuration is constructed without pins coinciding with the first and second power supply pads and traces (VCCA, VCCB1).
Complementary ground pads and pins are also provided. The first and second IC packages may be used interchangeably in the same system board receptacle (20) without modification of the system board.

## Description

### Technical Field

This invention relates to a new system board receptacle and to new interchangeable integrated circuit packages for respective multiple and single power supply systems and subsystems. In particular, the invention relates to new complementary pad and pin configurations for the pads of a system board IC package receptacle and the pins of alternative IC devices to be inserted in the receptacle. The system board can provide multiple power supplies. The complementary pad and pin configurations can accommodate an IC device requiring multiple incompatible power supplies and signal logic voltage levels or an IC device requiring a single power supply and compatible signal logic voltage levels. The invention is applied for example to receive alternative translator and transceiver IC devices in the same IC package receiver without modifying the system board.

### Background Art

In 1992 the Joint Electron Device Engineering Council (JEDEC) of the Electronic Industries Association (EIA) adopted a new low voltage integrated circuit standard based on a 3.3v power supply. This new low voltage standard is designated the JEDEC Standard 8-1A and is now commonly known as the 3v standard. The new JEDEC Standard 8-1A at nominal 3.3v is to be contrasted with the conventional integrated circuit JEDEC Standards 18 & 20 with a 5v power supply. The 3v and 5v standards are incompatible with respect to voltage levels of the respective power supplies and the logic high and low potential level signals generated by the two different circuits.

For the conventional 5v standard, a CMOS logic low potential level signal is typically in the range of 0.4v - 0.55v while a logic high potential level signal is in the range of 3.65v - 4.0v. For the new 3v standard, JEDEC Standard 8-1A, a CMOS logic low potential level signal is also typically in the range of 0.4v - 0.55v while the logic high potential level signal is in the range of 2.0v - 2.4v. Because of the incompatibility of the 3v and 5v standard supply voltage levels and the respective CMOS logic high and low potential level signals, translation is required for communication between 3v and 5v standard subcircuits. The new low voltage standard for a power supply at nominal 3.3v is applicable for CMOS, bipolar, and BICMOS technology IC's.

Applications for the new 3v standard include notebook sub-notebook, hand held, and pen based portable and mobile personal computers, generally referred to as personal digital assistants or PDA's. The 3v standard requires less power dissipation from the battery power supplies for longer operating life. Another advantage of the new low voltage standard is that the new CMOS logic signal high and low potential levels are compatible with bipolar TTL circuit logic signal potential levels. A difficulty with application of the new 3v standard in notebook and PDA computers however is that all of the computer subsystems cannot necessarily be converted to the 3v standard. For example available disk drives continue to operate on the basis of the 5 volt standard and the disk drive subsystem including the disk controller must therefore be based on the 5v standard circuits.

In such a notebook or other PDA computer, the system board or motherboard includes the 3v microprocessor (µP) computer system and a plurality of ports for controlling peripherals such as a liquid crystal display (LCD) port, communications port RS232, power supply port, and external memory port. The disk drive port however may communicate with a 5 volt subsystem, namely the disk controller which operates the hard disk drive. A translator, an integrated circuit device for example in a dual inline package (DIP), is therefore required between the 3v µP system and the disk drive port and 5v disk drive controller subsystem. Such a 3v to 5v translator is provided for example by the National Semiconductor Corporation DIP translator device LVX4245 (TM).

A disadvantage of the conventional motherboard receptacle configuration however is that it is expected in the near future that 3v standard disk drives will become available with a disk controller also operating as a 3v standard subsystem. The multiple supply 3v to 5v translator IC device such as NSC LVX4245 (TM), a relatively expensive part at, for example $2.00, will therefore no longer be necessary and can be replaced by a relatively inexpensive single power supply transceiver IC device such as, for example, the National Semiconductor Corporation LVQ245 (TM) transceiver. More importantly, a reconfiguration will be required for the system board or motherboard, a far more expensive part, in the order of for example $100.00. The required redesign of such an expensive part as the motherboard is a cost to be avoided by the manufacturer.

### Objects of the Invention

It is therefore an object of the present invention to provide a new system board receptacle and receptacle pad configuration for accommodating IC devices and packages requiring either multiple power supplies or a single power supply.

Another object of the invention is to provide a new IC package and complementary IC package pin configurations for supporting subsystems and IC packages requiring different incompatible power supplies and logic signal high and low potential levels in the new system board receptacle. The invention also supports subsystems and IC packages requiring only a single power supply with compatible logic signal potential levels in the new system board receptacle. The complementary pad and pin configurations are intended to accommodate either subsystems and IC packages requiring different incompatible power supplies or subsystems and IC packages requiring only a single power supply with compatible logic signal potential levels at the same system circuit board receptacle without redesign and reconfiguration of the system board.

A further object of the invention is to provide complementary system board receptacle pad and IC package pin configurations to enable a system board to accommodate mixed 3v standard subsystems and 5v standard subsystems or exclusively 3v standard subsystems without redesign or reconfiguration of the system board. An advantage of the new complementary pad and pin configurations is that they enable a circuit board to accommodate TTL and CMOS subsystems and BICMOS subsystems on the same circuit board.

### Disclosure of the Invention

In order to accomplish these results the invention provides a new system board receptacle and new IC packages with complementary pad and pin configurations for the pads of the system board receptacle and the pins of the IC packages to be inserted in the receptacle. The system board is able to accommodate multiple power supplies. The system board receptacle pad configuration includes a first power supply pad and trace (VCCA) for coupling to a first power supply, and second and third power supply pads and traces (VCCB1,VCCB2) for coupling to a second power supply.

The invention also includes at least a first IC package requiring multiple power supplies. The pin configuration of the first IC package includes a first power supply pin (VCCA) coinciding with the first power supply pad and trace of the system board receptacle for supplying a portion of the integrated circuit of the first IC package with a first power supply. A second power supply pin (VCCB1) coincides with the second power supply pad and trace of the system board receptacle for supplying another portion of the integrated circuit of the first IC package with a second power supply different from the first power supply. The first IC package therefore utilizes both the first and second power supplies available on the system board.

A second IC package pin configuration is provided for a second IC package that requires only a single power supply. The second IC package pin configuration includes a single power supply pin (VCCB2) coinciding with the third power supply pad and trace of the system board receptacle. The second IC package pin configuration is constructed without pins coinciding with the first and second power supply pads and traces (VCCA,VCCB1) of the system board receptacle.

A feature of the invention is that the first IC package requiring multiple power supplies and the second IC package requiring only a single power supply may be used interchangeably in the same system board receptacle without modification of the system board.

In the preferred example, the first IC package is constructed so that the third power supply pin (VCCB2) is a "no-connect" pin or dead pin, without direct electrical connection to the integrated circuit of the second IC package. In this way, the first IC package pins fill all of the pin receivers of the system board receptacle. Alternatively, the second and third power supply pins are coupled together, or the third power supply pin is omitted. As used herein, "no-connect" pin is intended to include these alternative electrical equivalents.

The second IC package is constructed with a pin configuration having only a single power supply pin (VCCB2) coinciding with the third power supply pad and trace of the system board receptacle. The second IC package is constructed without pins coinciding with the first (VCCA) and second (VCCB1) power supply pads and traces of the system board receptacle. As a result, the second IC package pins do not fill all of the pin receivers of the system board receptacle and the pin count of the second IC package is less than the pin count of the first IC package.

According to invention, the system board receptacle is constructed with a pad configuration incorporating a plurality of ground pads and traces for coupling to ground. The first IC package is constructed with a plurality of ground pins coinciding with the plurality of ground pads and traces of the system board receptacle. Generally this plurality of ground pins is coupled to a common ground rail of the first IC package. The second IC package is constructed with only one ground pin coinciding with only one of the ground pads and traces of the system board receptacle. Again, the first IC package pins generally fill all the receivers of the system board receptacle while the second IC package pins fill only some of the pin receivers.

In the preferred example embodiment, the system board receptacle pad configuration includes fourth, fifth and sixth ground pads and traces (GND4,GND5,GND6) for coupling to ground. The first IC package pin configuration also includes fourth, fifth, and sixth ground pins (GND4,GND5,GND6) coinciding with the fourth, fifth, and sixth ground pads and traces of the system board receptacle. Generally the fourth, fifth, and sixth ground pins are coupled to a common ground rail of the first IC package. The second IC package pin configuration is constructed with only a fourth ground pin (GND4) coinciding with the fourth ground pad and trace of the system board receptacle. The second IC package is formed without pins coinciding with the fifth and sixth ground pads and traces (GND5,GND6) of the system board receptacle.

According to the preferred example embodiment the complementary pad and pin configurations each include at least two data ports (A,B) of respective multiple pads and traces for the system board receptacle and respective multiple pins for the IC packages. Input and output signals of logic high and low potential levels are received and transmitted at the respective data ports. The first IC package is a translator with different incompatible power supplies respectively supplying the first and second data ports. A translator circuit coupled between the data ports translates the potential levels of the incompatible logic signals. The second IC package is a transceiver supplying the first and second data ports from a single power supply for receiving and transmitting compatible logic signal high and low potential levels.

Generally, the invention provides a circuit board receptacle having n pin receivers arranged to receive IC packages. The circuit board supports multiple power supplies. The receptacle is constructed with a configuration of n pads and traces at the respective n pin receivers for supplying at least two different power supplies to a first IC package having n pins filling the n pin receivers of the receptacle. The configuration of n pads and traces is also constructed for supplying a single power supply to a second IC package having n-m pins filling n-m receivers of the receptacle where m<n. In the preferred example the receptacle is constructed for DIP's and m=4.

The complementary pad and pin configurations are applied to a system board such as a PC motherboard for a notebook personal computer or lap top personal computer in which the microprocessor uses a 3v standard power supply. However the disk drive port of the motherboard is coupled to a disk drive controller having a 5v standard power supply. The new system board receptacle is coupled between the 3v standard microprocessor and 5v standard disk drive port. The first IC package translator translates between the 3v and 5v standard power supplies. When a 3v standard disk drive subsystem becomes available the same system board receptacle can be used for a transceiver operating at the single 3v standard without redesign and reconfiguration of the motherboard. The invention is also applicable to systems with bipolar subsystems, mixed bipolar TTL/CMOS subsystems, CMOS subsystems, and BICMOS subsystems.

Other objects features and advantages of the invention are apparent in the following specification and accompanying drawings.

### Brief Description of the Drawings

Figure 1 is a simplified detailed fragmentary and diagrammatic side view of portions of a prior art PWELL technology CMOS wafer showing the common power supply coupling permitting only a single power supply.

Figure 2 is a simplified detailed fragmentary and diagrammatic side view of portions of an NWELL technology CMOS wafer with isolated bulk NWELL couplings to different high voltage sources permitting multiple isolated power supplies according to the invention.

Figure 3 is a detailed diagrammatic plan view of the new complementary pad and pin configuration for the system board receptacle and a first IC package translator.

Figure 4 is a simplified diagrammatic plan view of the new complementary pad and pin configuration for the system board receptacle and a second IC package transceiver.

Figure 5 is a system block diagram showing the power rail couplings for the first IC package and system board receptacle where the system board supports both 5v and 3v subsystems and separate isolated 5v and 3v power supplies.

Figure 6 is another system block diagram showing the power rail couplings for the second IC package in the same system board receptacle where the same system board supports all 3v subsystems requiring only a single 3v power supply.

### Description of Preferred Example Embodiments and Best Mode of the Invention

The implementation of the present invention requires IC technologies that-provide isolation of the power supply applicable to different transistors on the same chip or die. This is necessary to support multiple different power supplies within the same IC device or IC package die and is not possible in prior art PWELL CMOS technology.

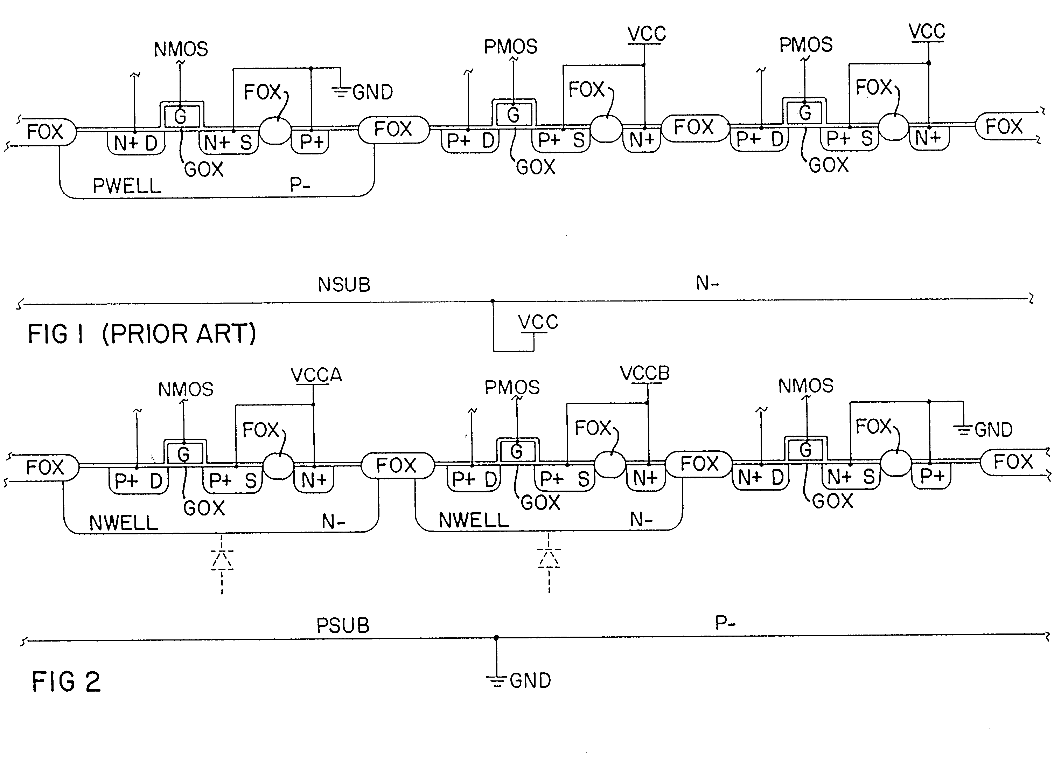

An example of the prior art PWELL CMOS technology is illustrated in Fig. 1. Separate PWELL's of P type carrier doped semiconductor material are formed in a common N type substrate NSUB which is coupled to a common high potential power rail VCC. The PWELL's form isolated regions underlying each of the NMOS or N channel transistors. The source N+S and drain N+D are formed in the PWELL with an overlying gate G separated by a gate oxide layer GOX. The NMOS transistor is isolated from other transistor devices by field oxide regions FOX.

The N type substrate NSUB is coupled to a common high potential power rail VCC. The PWELL is tied to a ground potential rail GND. The source N+S of the NMOS transistor is also tied to the ground potential rail GND through the PWELL. It is apparent that the ground couplings of the NMOS transistors may be isolated from each other because of the isolation of the respective PWELL's in the N type substrate NSUB.

The disadvantage of the prior art PWELL CMOS technology is that the sources P+S of the respective NMOS transistors are tied to a common supply rail VCC and power supply VCC through the substrate NSUB as illustrated in Fig. 1. The common or bulk coupling of the substrate NSUB to the high potential power rail VCC prevents isolation of the supply rail coupling of respective PMOS transistors and limits application of the PWELL CMOS technology to single supply systems.

As shown in Figs. 1 and 2 the designation of N type carrier semiconductor material indicates semiconductor material doped with atoms yielding negative charge carriers while the designation P type semiconductor material indicates semiconductor material doped with atoms yielding positive charge carriers or holes. The relative concentration of doping ions or atoms and corresponding N or P type carriers is indicated over a range from lower concentration to higher concentration by respective minus signs (-) or plus signs (+). Thus in the range of concentration of N type carriers N- < N <N+ and for P type carriers P- < P <P+.

An integrated circuit technology which permits isolation of power supplies is the NWELL CMOS and BICMOS wafer fabrication technologies in which separate NWELL's of N type carrier doped semiconductor material are formed in a common grounded P type substrate PSUB as illustrated in Fig. 2. The NWELL's form isolated regions underlying each of the P channel PMOS transistors. The source P+S and drain P+D are formed in the NWELL with an overlying gate G separated by a gate oxide layer GOX. The PMOS transistors are isolated from other transistor devices by field oxide regions FOX. While the P type substrate PSUB is grounded to a common ground GND, the NWELL is tied to a high potential power rail, for example VCCA or VCCB. The source P+S is also tied to one of the high potential power rails VCCA,VCCB through the NWELL.

The advantage of this integrated circuit configuration is that the power supply coupling to each transistor device of the integrated circuit chip is isolated from the power supply coupling to other transistor devices by the respective isolation of the NWELL of each transistor device. This is also true of the N channel or NMOS transistors in the NWELL CMOS and BICMOS technologies as illustrated in Fig. 2. The drains N+D of the N channel or NMOS transistors which are coupled to the high potential power rail VCCA or VCCB are also isolated from each other by the P type substrate PSUB. This permits the use of multiple different and incompatible power supplies coupled to different transistor devices of the same integrated circuit chip without a common coupling between the different power supplies. For example, as shown in Fig. 2, different PMOS transistors are coupled to different supply rails VCCA,VCCB such as a 5v standard rail and a 3v standard rail with isolation of the different power supplies.

On the other hand, the ground couplings of the respective transistor devices are tied to the common ground of the substrate PSUB. The ground couplings are therefore generally not isolated relative to each other without special measures such as the use of silicon or semiconductor material on sapphire substrate (SOS) or silicon or other semiconductor material on another insulator substrate (SOI).

A comparable technology in bipolar IC fabrication which permits isolated power supplies is the N type buried layer technology in which an isolated N+ buried layer is formed in a common grounded P type substrate underlying each of the NPN bipolar transistors. The collector of the NPN transistor is tied to the N+ buried layer through a collector sink region and is coupled to the high potential power rail power supply VCC. The power supply couplings of each NPN transistor are therefore isolated relative to each other by the isolated N type carrier buried layers in a P type substrate permitting the use of multiple different or incompatible power supplies.

In contrast to this, for example, a PWELL CMOS or BICMOS technology utilizes P type semiconductor material PWELL's in an N type substrate NSUB. The substrate NSUB is coupled to a common high potential power rail power supply VCC as illustrated in Fig. 1. In this PWELL CMOS technology while isolated ground couplings are available, the power supplies are tied together through the common N type substrate NSUB coupled to VCC. Power supplies cannot be isolated without special measures such as SOS or SOI referred to above.

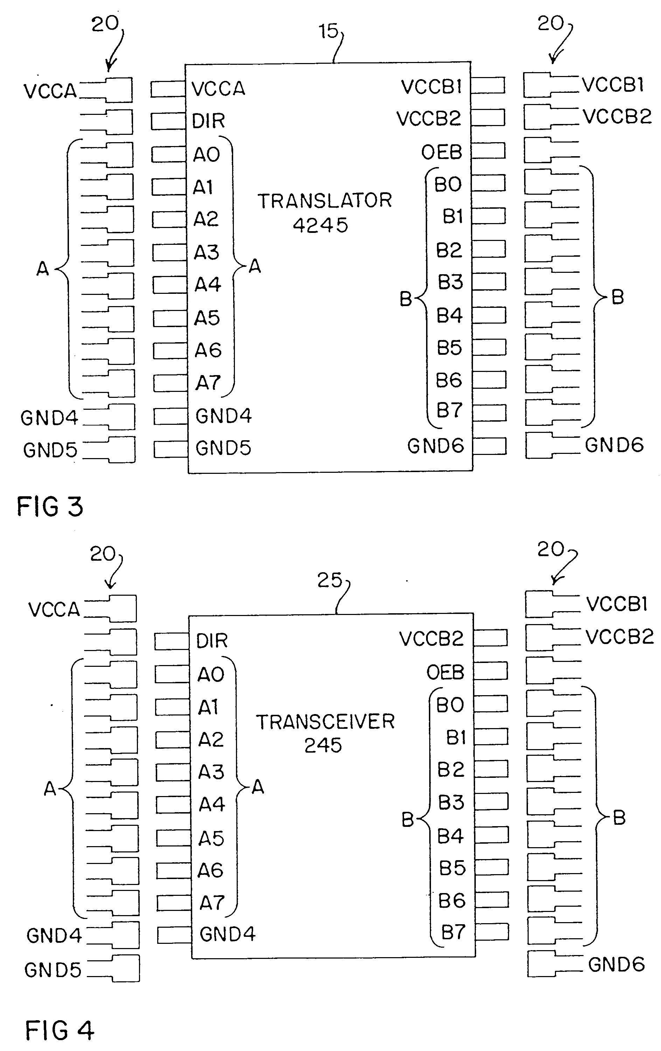

Complementary pad and pin configurations for a system board receptacle 20 and a translator integrated circuit device or package 15 fabricated, for example, using NWELL CMOS technology, BICMOS technology, or N type buried layer bipolar technology are illustrated in Fig. 3. As shown in Fig. 3, the system board receptacle 20 consists of two rows of pads with fragmentary portions of only the printed circuit board traces shown extending from the pads. Each of the rows includes a set of eight pads and traces forming the bidirectional ports A,B for receiving and transmitting eight bit input and output signals of logic high and low potential levels. Three power supply pads and traces VCCA,VCCB1,VCCB2 and three ground pads and traces GND4,GND5,GND6 are organized at the ends of the rows of pads as illustrated in Fig. 3.

The bidirectional receptacle 20 includes a directional signal pad and trace DIR. A directional signal 0 or 1 is applied at the corresponding DIR pin of a bidirectional IC package such as a bidirectional translator or transceiver to set the direction of signal propagation.

The translator IC package 15 also incorporates eight bit pins A0...A7, B0...B7 at bidirectional ports A,B for input and output signals corresponding to pads of the receptacle ports A,B. The translator 15 is provided with three power supply pins VCCA,VCCB1,VCCB2 coinciding with the corresponding power supply pads and traces of the receptacle 20. Similarly the translator IC package 15 is formed with three ground pins GND4,GND5 and GND6 coinciding with the corresponding ground pads and traces of the receptacle 20.

In this example the power supply pad and trace VCCA of the circuit board receptacle 20 are coupled to a 5v standard power supply for supplying translator circuitry of the translator device 15 coupled to the A port pins A0...A7. The power supply pad and trace VCCB1 of the circuit board receptacle 20 are coupled to a 3v standard power supply for supplying translator circuitry coupled to the B port pins B0...B7. The B port pins receive signals for example from a 3v standard microprocessor µP of a notebook personal computer NBPC or other mobile computer or personal digital assistant PDA. The translator translates the respective voltage levels of the power supply and logic high and low potential signals from a 3v standard to a 5v standard through appropriate translator circuitry coupled between the B port pins B0...B7 and A port pins A0...A7 of the IC device 15. The A port pads form part of the disk drive port for transmission of appropriate 5v standard logic high and low potential level signals to the disk drive controller (not shown) of a 5v standard disk drive.

In the embodiment of Fig. 3 the third power supply pad and trace VCCB2 of the system board receptacle 20 is coupled to a 3v standard power supply for use as hereafter described with reference to Fig. 4. In the first IC package 15 of Fig. 3 the third power supply pin VCCB2 is a no-connect pin or dead pin without any coupling to the integrated circuit of the translator 15. The three ground pins GND4,GND5 and GND6 of the translator IC package 15 are coupled to a common ground rail GND as a result of the common ground coupling of the P type substrate PSUB of the NWELL CMOS technology used in fabricating the translator chip.

A second IC package 25 with a pin configuration for use with the same receptacle 20 and pad configuration described in Fig. 3 is illustrated in Fig. 4. In this example the second IC package is a transceiver device 25 with a similar pair of ports A,B of multiple pins A0...A7, B0...B7 for transmitting and receiving eight bit input and output signals. In this example the transceiver circuit and integrated circuit portions coupled to the pins of both port A and port B are supplied by the same power supply and supply rail coupled through the receptacle pad and trace VCCB2 and corresponding pin VCCB2 of the transceiver 25.

According to this example the power supply coupled to pad and pin VCCB2 is a 3v standard power supply. The transceiver receives and transmits input and output signals with compatible logic high and low potential levels between a 3v standard microprocessor µP and a 3v CMOS standard peripheral device or subsystem. For example it is expected in the near future that 3v standard disk drives and disk drive controllers will become available making possible an all 3v standard power supply notebook or PDA personal computer system. When this becomes available, the transceiver device 25 can replace the translator device 15 on the same motherboard without costly redesign and reconfiguration of the motherboard and its receptacle 20.

As illustrated in Fig. 4, the second IC package transceiver 25 is constructed with four less pins than the first IC package translator 15. For example, the translator 15 is a 24 pin package and the transceiver 25 is a 20 pin package. Transceiver 25 is formed without the first and second power supply pins VCCA, VCCB1. It is also formed without the ground pins GND5,GND6.

The multiple power supply receptacle 20 is thus formed with a pad and trace configuration with six power pads or power rail pads. The first, second, and third power pads, VCCA,VCCB1,VCCB2 are supply pads while the fourth, fifth, and sixth power pads GND4,GND5,GND6 are ground pads. These power rail pads are distributed at the ends of two parallel rows of pads forming the ends or corners of a rectangular receptacle. The first IC package pin configuration of IC device 15 is formed with six power pins coinciding with the six power pads. The power pins are positioned at the ends of the two parallel rows of pins, i.e. the corners of the rectangular DIP. However, the third power supply pin VCCB2, one of the supply pins, is a no connect pin with no connection to the integrated circuit of the device. Alternatively the third power supply pin VCCB2 may be shorted or bonded to the second power supply pin VCCB1 or it may simply be omitted. Furthermore the fourth, fifth, and sixth power pins, the ground pins, GND4,GND5, and GND6 are generally coupled to the same power rail through the common ground coupling of a commonly grounded substrate.

The second IC package 25 is formed with four fewer pins. It is formed without the first and second power pins, namely supply pins VCCA,VCCB1. It is also formed without the fifth and sixth power pins, namely the ground pins GND5,GND6. The omitted pins are at the ends of the parallel rows of pins resulting in the shorter rectangular DIP with reduced pin count. By the respective complementary pad and pin configurations the multiple supply first IC package 15 and single supply second IC package 25 can be used interchangeably in the same system board receptacle 20.

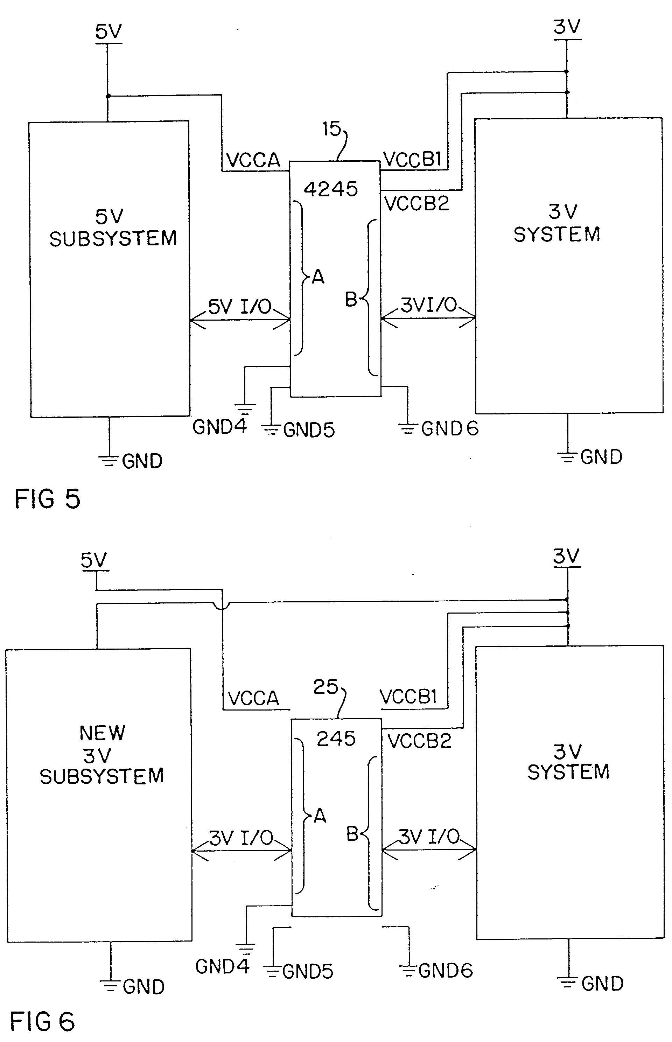

System configurations for the new system board receptacle 20 and first and second IC packages 15,25 are illustrated respectively in Figs. 5 and 6. As shown in Fig. 5, a system board or motherboard incorporates a 3v computer system or microprocessor system and a 5 volt subsystem or peripheral such as a disk drive controller. The IC device translator 15 is a generic 4245 translator such as the National Semiconductor Corporation LVX4245 (TM) translator in the configuration of a 24 pin dual inline package. The translator is coupled between the 3v system and 5v subsystem in the system board receptacle 20, not shown in entirety. In the system block diagram of Fig. 5 only the power rail couplings of the system board receptacle and IC package translator 15 are shown. At one end of the DIP are the three complementary power supply pads and pins VCCA,VCCB1,VCCB2 while at the other end of the DIP are the three complementary ground pad and pin couplings GND.

As illustrated in Fig. 5 the VCCA pad and trace supply the 5 volt power supply to the portions of the integrated circuit coupled to the A port pins of translator 15. The VCCB1 pad and trace supply the 3.3 volt power supply to the B port pins of the translator 15. The VCCB2 pad and trace while being coupled to the 3v standard power supply is coupled to a no-connect pin or dead pin of the translator 15 or the VCCB2 pin of translator 15 is omitted or shorted to the VCCB1 pin. The three ground pads and traces GND 4,GND5, and GND6 at the other end of the DIP are coupled to the common ground rail coupling GND. The multiple ground leads provide reduced parasitic inductance in the lead frame fingers of the IC package 15. The bidirectional translator 15 can receive 3v standard input signals from the 3v system and deliver 5v standard output signals to the 5v subsystem. Alternatively the translator 15 may receive 5v input signals at the A port from the 5v subsystem and deliver 3v standard output signals at the B port to the 3v system.

As illustrated in Fig. 6 a new 3v subsystem has been substituted for the 5v subsystem on the same system board or motherboard as in Fig. 5. The same system board receptacle 20 not shown in entirety remains unmodified between the 3v system and the new 3v subsystem. Instead of the more expensive translator package 15, however, a simpler and less expensive bidirectional transceiver 25 has been substituted. The transceiver 25 is a generic 245 transceiver such as is provided, for example, by the National Semiconductor Corporation LVQ245 (TM) transceiver package.

Unlike the translator 15, the transceiver 25 is a 20 pin DIP with four pins less than the translator DIP 15. The transceiver 25 makes no use of the two pads and traces at each end of the receptacle 20 and uses only the intermediate 20 pads and traces. As a result the connection of the IC package to the 5v supply is truncated and the 5v supply is no longer connected to any portion of the system board motherboard and peripherals.

The new substitute 3v subsystem such as, for example, a new 3v disk drive controller is coupled to the 3v supply rather than the 5v supply. Nor is the second power supply pad and trace VCCB1 utilized. The pad and trace VCCB1 remains open ended. The 3v standard power supply is coupled to the transceiver 25 through the third complementary power supply pad and pin VCCB2 only. Similarly only the fourth ground pad and trace GND4 of the receptacle 20 is coupled to the corresponding pin of transceiver 25 while the ground pads and traces GND5,GND6 remain open ended.

In operation of the new system configuration, 3v standard input signals from the 3v computer system at the port B pins of transceiver 25 are delivered as 3v standard output signals at the port A pin to the 3v subsystem such as a 3v disk drive controller. Similarly 3v standard input signals from the new 3v subsystem at the port A pins are delivered as 3v output signals at the port B pins to the 3v host system. By the complementary pad and pin configurations of the system board receptacle and first and second IC packages, systems and subsystems requiring either multiple power supplies or a single power supply can be accommodated without modification of the system board design configuration.

Also as used herein, "no connect pin" with reference to the third power supply pin VCCB2 of the first IC package 15 refers to a pin without direct connection to the integrated circuit of the first IC package and includes a third pin which may be shorted or connected to the second power supply pin VCCB1 or which may be omitted from the first IC package entirely. These are all equivalent electrical arrangements for a third pin VCCB2 which has no direct connection to the integrated circuit of the IC package.

While the invention has been described with reference to multiple power supplies incorporating the 3v standard and 5v standard for supplying respective ports or respective portions of a first IC package 15, the invention is applicable to other combinations of different or incompatible power supplies. For example the complementary pad and pin configuration may be useful in integrating standard 5v bipolar TTL circuits on the same chip with either 3v CMOS standard circuits or 5v CMOS standard circuits. In either case the appropriate translator circuits are provided in the first IC package with isolated power supplies supplying respective circuit portions. Other possible applications include for example combining 12v power supply circuits for automotive applications with 3v standard or 5v standard computer circuit requirements.

Furthermore, the invention has been described with reference to dual in-line package (DIP) or plastic DIP IC packages and generic 74 series pin assignments. However the invention is also applicable to other IC packages such as small outline IC packages (SOIC) and scaled small outline packages (SSOP) and respective SOIC and SSOP pin assignments. The invention is therefore intended to cover all modifications and equivalents within the scope of the following claims.

## Claims

1. A circuit board receptacle for receiving at least first and second IC packages, said first IC package requiring at least first and second different power supplies for supplying first and second portions of the integrated circuit of the first IC package, said first IC package having a pin configuration comprising at least first and second power supply pins (VCCA,VCCB1) coupled to the first and second portions of the integrated circuit of the first IC package, said second IC package requiring a single power supply and having a pin configuration comprising a single power supply pin (VCCB2) coupled to the integrated circuit of the second IC package for supplying the single power supply, comprising:
said system board receptacle (20) being constructed with a pad configuration comprising a first power supply pad and trace (VCCA) for coupling to a first power supply, said first power supply pad coinciding with the first power supply pin (VCCA).of the first IC package;
said system board receptacle (20) pad configuration comprising a second power supply pad and trace (VCCB1) for coupling to a second power supply, said second power supply pad and trace coinciding with the second power supply pin (VCCB1) of the first IC package;
said pad configuration comprising a third power supply pad and trace (VCCB2) for coupling to the second power supply, said third power supply pad and trace coinciding with the single power supply pin (VCCB2) of the second IC package.

2. The circuit board receptacle of claim 1 wherein the first IC package is constructed with a third power supply pin (VCCB2) without direct connection to the integrated circuit of the first IC package, said circuit board receptacle being constructed with a third power supply pad and trace (VCCB2) coinciding with said third power supply pin (VCCB2) of the first IC package.

3. The circuit board receptacle of claim 1 wherein the first IC package (15) comprises fourth, fifth, and sixth ground pins (GND4,GND5,GND6) for coupling to ground and wherein the second IC package comprises a single ground pin (GND4) for coupling to ground, said circuit board receptacle (20) pad configuration comprising fourth, fifth, and sixth ground pads and traces (GND4,GND5,GND6) coinciding with the fourth, fifth, and sixth ground pins of the first IC package, said fourth ground pad and trace (GND4) coinciding with the single ground pin (GND4) of the second IC package.

4. The circuit board receptacle of claim 3 wherein the system board receptacle (20) comprises two parallel rows of pads and traces and wherein the power supply pads and traces and ground pads and traces occupy respective ends of the parallel rows defining four corners of the receptacle (20).

5. The circuit board receptacle of claim 4 wherein the first and second power supply pads and traces (VCCA,VCCB1) occupy respective ends of the two parallel rows at one end and wherein the fifth and sixth ground pads and traces (GND5,GND6) occupy respective ends of the two parallel rows at the other end, wherein the third power supply pad and trace (VCCB2) is adjacent to one of the first and second power supply pads and traces, and wherein the fourth ground pad and trace (GND4) is adjacent to one of the fifth and sixth ground pads and traces (GND5,GND6), whereby the circuit board receptacle (20) is able to accommodate a second IC package (25) having a pin configuration with four less pins than the pin configuration of the first IC package (15), said first IC package (15) having four additional pins (VCCA,VCCB1,GND5,GND6) at said four ends or four corners.

6. A first integrated circuit (IC) package (15) requiring at least first and second different power supplies, said first IC package (15) to be inserted in a circuit board receptacle (20) having a pad configuration constructed with a first power supply pad and trace (VCCA) for coupling to a first power supply, a second power supply pad and trace (VCCB1) for coupling to a second power supply, and a third power supply pad and trace (VCCB2) for coupling to the second power supply, comprising:
said first IC package being constructed with a pin configuration having a first power supply pin (VCCA) coinciding with the first power supply pad and trace of the circuit board receptacle (20) for coupling to the first power supply, a second power supply pin (VCCB1) coinciding with the second power supply pad and trace of the circuit board receptacle (20) for coupling to the second power supply, and a third pin (VCCB2) coinciding with the third power supply pad and trace of the system board receptacle (20), said third pin being a no connect pin without direct connection to the integrated circuit of the first IC package.

7. The IC package of claim 6 comprising a second IC package requiring only a single power supply, said second IC package being constructed with a pin configuration having a single power supply pin (VCCB2) coinciding with the third power supply pad and trace of the circuit board receptacle (20) for coupling to the second power supply, said second IC package (25) pin configuration being constructed without pins coinciding with the first and second power supply pads and traces (VCCA)(VCCB1) of the circuit board receptacle.

8. The integrated circuit package of claim 6 wherein the system board receptacle (20) to receive the first IC package comprises fourth, fifth, and sixth ground pads and traces (GND4,GND5, GND6) for coupling to ground, said first IC package (15) being constructed with a pin configuration having fourth, fifth, and sixth ground pins (GND4,GND5,GND6) coinciding with the fourth, fifth and sixth ground pads and traces of the system board receptacle.

9. The integrated circuit package of claim 7 wherein the circuit board receptacle (20) pad configuration is constructed with fourth, fifth, and sixth ground pads and traces (GND4,GND5,GND6) for coupling to ground, wherein the first IC package (15) is constructed with a pin configuration having fourth, fifth, and sixth ground pins (GND4,GND5,GND6) coinciding with the fourth, fifth, and sixth ground pads and traces of the system board receptacle (20), and wherein the second IC package (25) is constructed with a pin configuration having a single ground pin (GND4) coinciding with the fourth ground pad and trace of the system board receptacle (20), said second IC package (25) being constructed without ground pins coinciding with the ground pads and traces (GND5,GND6) of the system board receptacle (20).

10. A system board receptacle (20) and at least one IC package (15,25) to be inserted in the receptacle (20), said system board accommodating multiple power supplies, comprising:
said system board receptacle (20) being constructed with a pad configuration comprising a first power supply pad and trace (VCCA) for coupling to a first power supply, and second and third power supply pads and traces (VCCB1,VCCB2) for coupling to a second power supply;
and at least a first IC package (15) having a pin configuration comprising a first power supply pin (VCCA) coinciding with the first power supply pad and trace of the system board receptacle (20) for supplying portions of the integrated circuit of said first IC package from a first power supply, and a second power supply pin (VCCB1) coinciding with the second power supply pad and trace of the system board receptacle (20) for supplying other portions of the integrated circuit of the first IC package (15) from a second power supply different from the first power supply.

11. The receptacle and package of claim 10 wherein the first IC package comprises a third pin coinciding with the third power supply pad and trace of the system board receptacle, said third pin not being connected directly to the integrated circuit of the first IC package.

12. The receptacle and package of claim 10 comprising a second IC package (25) having a pin configuration comprising a single power supply pin (VCCB2) coinciding with the third power supply pad and trace (VCCB2) of the system board receptacle (20), said second IC package (25) being constructed without pins coinciding with the first and second power supply pads and traces (VCCA, VCCB1) of the system board receptacle (20), whereby the first and second IC packages (15,25) may be used interchangeably in the same system board receptacle (20) without modification of the system board.

13. The receptacle and package of claim 12 wherein the system board receptacle (20) comprises fourth, fifth, and sixth ground pads and traces (GND4,GND5,GND6) for coupling to ground;
wherein the first IC package (15) comprises fourth, fifth, and sixth ground pins (GND4,GND5,GND6) coinciding with the fourth, fifth and sixth ground pads and traces of the system board receptacle (20);
and wherein the second IC package (25) is constructed with a fourth ground pin (GND4) coinciding with the fourth ground pad and trace of the receptacle (20) and is formed without pins coinciding with the fifth and sixth ground pads and traces (GND5,GND6) of the system board receptacle (20).

14. The receptacle and package of claim 13 wherein the first IC package (15) is constructed with four more pins than the second IC package (25), said four pins comprising the first and second power supply pins (VCCA,VCCB1) and the fifth and sixth ground pins (GND5,GND6).

15. The receptacle and package of claim 14 wherein the first IC package (15) comprises a dual inline package (DIP) of dual rows of pins;
wherein the four more pins (VCCA,VCCB1,GND5,GND6) are positioned respectively at the four corners or four ends of the dual rows of pins of the first IC package DIP;
and wherein the corresponding pads and traces of the system board receptacle (20) are positioned at four corners or four ends of dual rows of pads and traces corresponding to the dual rows of pins of the DIP.

16. The receptacle and package of claim 15 wherein the first IC package is a translator (15) requiring multiple different power supplies and the second IC package is a transceiver (25) requiring a single power supply.

17. The receptacle and package of claim 16 wherein the first power supply is a 3v standard power supply and the second power supply is a 5v standard power supply and wherein the first IC package is a 3v standard to 5v standard translator (15).

18. The receptacle and package of claim 17 wherein the second IC package is a 3v standard transceiver (25).

19. The receptacle and package of claim 18 wherein the system board comprises a PC motherboard for a microprocessor using a 3v standard power supply, said motherboard having a disk drive port coupled to a disk drive controller having a 5v standard power supply, said translator (15) and system board receptacle (20) being coupled between the microprocessor and disk drive port for translation between the 3v standard power supply and the 5v standard power supply.

20. The receptacle and package of claim 19 wherein the first IC package translator (15) is constructed using NWELL CMOS technology with NWELL's in a common grounded P type substrate (PSUB) for isolation of the multiple power supplies.

21. A system board receptacle (20) and at least one IC package (15,25) to be inserted in the receptacle (20), for a system board accommodating multiple power supplies, comprising:
said system board receptacle being constructed with a pad configuration comprising a first power supply pad and trace (VCCA) for coupling to a first power supply, a second power supply pad and trace (VCCB1) for coupling to a second power supply, and a third power supply pad and trace (VCCB2) for coupling to the second power supply, said system board receptacle (20) also comprising at least two data ports (A,B) of respective multiple pads and traces for receiving and transmitting input and output signals of logic high and low potential levels;
and at least a first IC package (15) having a pin configuration having first and second data ports (A,B) of respective multiple pins (A0...A7, B0...B7) respectively operating from different first and second power supplies, said IC package (15) pin configuration comprising a first power supply pin (VCCA) coinciding with the first power supply pad and trace (VCCA) of the system board receptacle (20) for supplying portions of a circuit coupled to the first data port (A), and a second power supply pin (VCCB1) coinciding with the second power supply pad and trace (VCCB1) of the receptacle (20) for supplying portions of a circuit coupled to the second data port (B);
said first IC package pin configuration being constructed with a no-connect pin coinciding with the third power supply pad and trace (VCCB2) of the system board receptacle (20).

22. The receptacle and package of claim 21 comprising a second IC package (25) having a pin configuration with first and second data ports (A,B) of respective multiple pins (A0...A7,B0...B7) operating from a single power supply for receiving and transmitting respective input and output multi-bit signals at the same compatible logic high and low potential levels, said second IC package (25) comprising a single power supply pin (VCCB2) coinciding with the third power supply pad and trace (VCCB2) of the system board receptacle (20);
said second IC package (25) being constructed without pins coinciding with the first and second power supply pads and traces (VCCA, VCCB1) of the system board receptacle (20);
whereby the first IC package requiring multiple supplies and second IC package requiring a single supply may be used interchangeably in the same system board receptacle (20) without modification of the system board.

23. The receptacle and package of claim 22 wherein the system board receptacle (20) pad configuration comprises fourth, fifth and sixth ground pads and traces (GND4,GND5,GND6) for coupling to ground;
wherein the first IC package (15) pin configuration comprises fourth, fifth and sixth ground pins (GND4,GND5,GND6) coinciding with the fourth, fifth and sixth ground pads and traces of the system board receptacle (20);
and wherein the second IC package (25) pin configuration is constructed with a fourth ground pin (GND4) coinciding with the fourth ground pad and trace of the receptacle (20) and is formed without pins coinciding with the fifth and sixth ground pads and traces (GND5,GND6) of the receptacle (20).

24. The receptacle and package of claim 22 wherein the first power supply is a 5v standard power supply, wherein the second power supply is a JEDEC Standard 8-1A 3v standard power supply, wherein the first IC package is a 3v standard to 5v standard translator, and wherein the third power supply is a JEDEC Standard 8-1A 3v standard power supply.

25. The receptacle and package of claim 23 wherein the first IC package (15) pin configuration is constructed with four more pins than the second IC package (25) pin configuration, said four pins comprising the first and second power supply pins (VCCA, VCCB1) and the fifth and sixth ground pins (GND5,GND6).

26. The receptacle and package of claim 25 wherein the first IC package (15) pin configuration comprises a dual inline package (DIP) of dual rows of pins;
wherein the four more pins (VCCA,VCCB1,GND5,GND6) are positioned respectively at the four corners or four ends of the dual rows of pins of the first IC package DIP;
and wherein the corresponding pads and traces of the system board receptacle (20) pad configuration are positioned at four corners or four ends of dual rows of pads and traces corresponding to the dual rows of pins of the DIP.

27. The receptacle and package of claim 24 wherein the first IC package is constructed using NWELL CMOS technology with NWELL's in a common grounded P type substrate (PSUB) for isolation of multiple power supplies.

28. The receptacle and packages of claim 24 wherein the system board comprises a PC motherboard for a microprocessor using a 3v standard power supply, said motherboard having a disk drive port coupled to a disk drive controller having a 5v standard power supply, said translator (15) and system board receptacle (20) being coupled between the microprocessor and disk drive port for translation between the 3v standard power supply and corresponding logic high and low potential level signals and the 5v standard power supply and corresponding logic high and low potential level signals.

29. A circuit board receptacle having n pin receivers arranged to receive IC packages, said circuit board supporting multiple power supplies, said receptacle having a configuration of n pads and traces at the respective n pin receivers for supplying at least two different power supplies to a first IC package having n pins filling the n pin receivers of the receptacle, said configuration of n pads and traces being constructed for supplying a single power supply to a second IC package having n-m pins filling n-m pin receivers of the receptacle where m<n.

30. The circuit board receptacle of claim 29 where m=4.
